# EUROPÄISCHE PATENTSCHRIFT

(11) **EP 3 477 790 B1**
(45) Veröffentlichungstag und Bekanntmachung des Hinweises auf die Patenterteilung: **04.10.2023**
(21) Anmeldenummer: 18000811.2
(22) Anmeldetag: 15.10.2018
(51) Int. Cl.: H03K 17/10, H01R 13/703, H01M 50/574

(54) **GERÄT ZUM EINSATZ IM EX-BEREICH**
DEVICE FOR USE IN THE EX AREA
APPAREIL À UTILISER DANS UNE ZONE À RISQUE D'EXPLOSION

(30) Priorität: 26.10.2017 DE 102017010107
(43) Veröffentlichungstag der Anmeldung: 01.05.2019
(73) Patentinhaber: Bartec GmbH, 97980 Bad Mergentheim (DE)
(72) Erfinder: Emmert, Wolfgang, 97877 Wertheim (DE); Kuhn, Sebastian, 97950 Großrinderfeld-Ilmspan (DE); Lanig, Ralph, 97990 Weikersheim-Laudenbach (DE)
(74) Vertreter: Kohl, Karl-Heinz

(56) Entgegenhaltungen:
- DE-A1- 10 049 346
- DE-A1- 19 748 553
- DE-A1- 19 838 492
- DE-A1-102006 047 039

## Beschreibung

Die Erfindung betrifft ein Gerät zum Einsatz im Ex-Bereich, also in explosionsgefährdeten Zonen, nach dem Oberbegriff des Anspruches 1.

In Ex-Bereichen werden elektrische Geräte eingesetzt, die mit einem Energieversorgungsteil in Form wenigstens einer Batterie oder wenigstens eines Akkus ausgerüstet sind. Solche Geräte sind beispielsweise Messgeräte, Panels, Analysengeräte, mobile Computer und dergleichen. Ein Wechsel des Energieversorgungsteiles im Ex-Bereich ist nicht möglich, weil im Kontaktbereich zwischen den Versorgungskontakten, mit denen das Gerät und das Energieversorgungsteil oder -modul elektrisch miteinander verbunden sind, ein Zündfunke entstehen kann, der eine Zündung einer explosionsfähigen Atmosphäre im Ex-Bereich auslösen kann. Aus diesem Grunde müssen die Geräte für den Wechsel des Energieversorgungsteiles aus dem Ex-Bereich entfernt werden, um im sicheren Bereich den Wechsel des Energieversorgungsteiles durchzuführen.

Bei dem bekannten Gerät (DE 198 38 492 A1) ist eine Steckverbindungsanordnung zwischen einer Stromversorgung und einem Verbraucher vorgesehen. Die Steckverbindungsanordnung hat zwei Steckverbinder sowie eine Schaltereinrichtung, der eine Steuereinrichtung zugeordnet ist. Sie arbeitet mit einem Steuersignal, das vom jeweils anderen Steckverbinder kommt. Die Steuereinrichtung bringt die Schaltereinrichtung dann in einen niederohmigen Zustand, wenn ein Steckerstift des einen Steckverbinders mit einer Steckbuchse des anderen Steckverbinders eine zuverlässige elektrisch leitende Verbindung bildet.

Es ist eine Kontaktverbindung bekannt (DE 10 2006 047 039 A1), die zwei Kontaktteile zur lösbaren elektrischen Verbindung zweier Teilstücke eines Leistungsstranges aufweist. Zur Freischaltung des Leistungsstranges bei geschlossenen Kontaktelementen ist eine Sicherungseinrichtung vorgesehen, die ein Sensorsystem zur Erfassung einer geschlossenen Kontaktstellung der Kontaktteile umfasst. Die Kontaktverbindung wird durch das Sensorsystem und die Sicherungseinrichtung überwacht, so dass lediglich bei vollständig geschlossener Stellung der beiden Kontaktteile ein Stromfluss über die Kontaktverbindung zugelassen wird.

Aus der DE 197 48 553 A1 ist ein Einschub für einen elektrischen Schaltschrank bekannt, in dem sich Kontaktmittel befinden, die mittels einer zwischen zwei Endstellungen verlagerbaren Handhabe zwischen einer Betriebsstellung und einer Abschaltstellung umschaltbar sind.

Schließlich ist eine Steckeranordnung mit einem schwenkbaren Deckel bekannt (DE 100 49 346 A1), die zwei komplementäre Steckverbinder aufweist, die in einer Steckrichtung zusammengefügt werden können. Zur Reduzierung der Steckkräfte ist eine Kulissenführung vorgesehen, die an einem Gehäuse angebracht ist und einen in einem schwenkbaren Deckel befindlichen Kulissenstein aufweist. Durch Schließen des Deckels wird der Steckvorgang unterstützt.

Der Erfindung liegt die Aufgabe zugrunde, das gattungsgemäße Gerät so auszubilden, dass ein Wechsel des Energieversorgungsteiles im Ex-Bereich möglich ist.

Diese Aufgabe wird beim gattungsgemäßen Gerät erfindungsgemäß mit den kennzeichnenden Merkmalen des Anspruches 1 gelöst.

Das erfindungsgemäße Gerät zeichnet sich dadurch aus, dass den Versorgungskontakten des Gerätes und des Energieversorgungsteiles jeweils Schalter vorgeschaltet sind, mit denen vor dem Entfernen des Energieversorgungsteiles vom Gerät die Versorgungskontakte spannungslos geschaltet werden. Hierfür ist die Schaltung vorgesehen, welche die Schalter so ansteuert, dass die Versorgungskontakte spannungslos sind. Wenn daher anschließend die Versorgungskontakte von Gerät und Energieversorgungsteiles voneinander gelöst werden, kann in Folge des spannungslosen Zustandes kein Zündfunke entstehen. Darum kann im Ex-Bereich ein Wechsel des Energieversorgungsteiles durchgeführt werden.

Damit die Versorgungskontakte vor dem Lösen zuverlässig spannungslos gemacht werden können, ist das Gehäuse des Gerätes und/oder das Gehäuse des Energieversorgungsteiles mit wenigstens einer mehrstufigen Kulissenführung versehen, in die wenigstens ein Kulissenstein eingreift. Die Kulissenführung sorgt dafür, dass im Zusammenwirken mit dem Kulissenstein zunächst die Schaltung betätigt wird, welche die Versorgungskontakte, solange sie noch miteinander verbunden sind, spannungslos macht.

Die Kulissenführung ist so ausgebildet, dass beim Entfernen des Energieversorgungsteiles vom Gerät in einer ersten Stufe zunächst über die Schaltung die Versorgungskontakte spannungslos geschaltet werden.

In einer nachfolgenden Stufe werden dann erst die Versorgungskontakte von Gerät und Energieversorgungsteil voneinander gelöst.

Das erfindungsgemäße Gerät kann in allen definierten Ex-Bereichen (Zonen 0, 1, 2 sowie Divisions 1, 2) eingesetzt werden.

Vorteilhaft steuert die Schaltung die Schalter bei der Verbindung des Energieversorgungsteiles mit dem Gerät so an, dass die Versorgungskontakte erst dann Spannung haben können, wenn sie bereits zusammengesteckt sind.

Eine einfache, zuverlässige und kostengünstige Lösung besteht darin, als Schalter Transistoren, insbesondere FETs, zu verwenden.

Das Gerät und das Energieversorgungsteil weisen vorteilhaft jeweils wenigstens zwei Schalter auf, die unabhängig voneinander angesteuert werden. Durch diese Redundanz der Schalter wird eine hohe Sicherheit gewährleistet. Wird das Gerät beispielsweise in der Zone 1 eingesetzt, dann reichen zwei Schalter für das Gerät sowie das Energieversorgungsteil aus. Ist ein Einsatz in der Zone 0 vorgesehen, dann sind für das Gerät und das Energieversorgungsteil drei unabhängig voneinander ansteuerbare Schalter vorgesehen.

Die Schaltung ist vorteilhaft so ausgebildet, dass sie Steuersignale für Ansteuerschaltungen erzeugt, mit denen jeder einzelne Schalter unabhängig angesteuert werden kann.

Damit die Versorgungskontakte, über welche das Gerät und das Energieversorgungsteil miteinander elektrisch verbunden sind, zuverlässig spannungslos geschaltet werden können, weist bei einer vorteilhaften Ausführungsform die Schaltung geräteseitige und energieseitige Schaltelemente auf. Die geräteseitigen Schaltelemente betätigen die energieseitigen Schalter und die energieseitigen Schaltelemente die geräteseitigen Schalter. Durch diese gegenseitige Verschränkung ist sichergestellt, dass das Energieversorgungsteil im Ex-Bereich ausgetauscht werden kann, ohne dass ein Zündfunke entsteht. Ohne das geräteseitig ausgelöste Signal bleibt der Versorgungskontakt des Energieversorgungsteiles geschlossen. Ohne das vom Energieversorgungsteil ausgelöste Signal bleibt umgekehrt der Versorgungskontakt des Gerätes geschlossen.

Bei einer vorteilhaften Ausführungsform weist die Schaltung als Schaltelemente Flächenkontakte und mit ihnen zusammenwirkende Kontaktelemente auf, die vorzugsweise Federkontaktstifte sind. Beim Entfernen des Energieversorgungsteiles kommen zunächst die Kontaktelemente außer Eingriff mit den Flächenkontakten, wodurch die Versorgungskontakte, die noch miteinander verbunden sind, spannungslos gemacht werden.

23. Januar 2020 Um einen einfachen Einbau der Flächenkontakte zu ermöglichen, ist es vorteilhaft, wenn die Flächenkontakte auf einer Kurzschlussleiste vorgesehen sind. Auf ihr können die Flächenkontakte in der erforderlichen Lage positioniert werden. Die Kurzschlussleiste lässt sich dann mit den vormontierten Flächenkontakten einfach einbauen.

Vorteilhaft sind die Kontaktelemente auf einer Kontaktleiste angeordnet. Auch sie kann vorab mit den Kontaktelementen bestückt und anschließend in einfacher Weise montiert werden.

Die Schaltung kann als Schaltelemente auch Dauermagnete und Magnetsensoren aufweisen. Wird das Energieversorgungsteil vom Gerät gelöst, entfernen sich die Dauermagnete von den Magnetsensoren, wodurch die Schalter so angesteuert werden, dass sie die Versorgungskontakte zwischen dem Energieversorgungsteil und dem Gerät spannungslos schalten. Die Schaltung kann als Schaltelemente bei einer weiteren Ausführung Näherungssensoren und mit ihnen zusammenwirkende induktive oder kapazitive Elemente aufweisen. Wird das Energieversorgungsteil vom Gerät abgenommen, verlassen die induktiven oder kapazitiven Elemente den Erfassungsbereich der Näherungssensoren, die dann über die Schalter die Versorgungskontakte spannungslos machen.

Weitere Merkmale der Erfindung ergeben sich aus den weiteren Ansprüchen, der Beschreibung und den Zeichnungen.

Die Erfindung wird anhand einiger in den Zeichnungen dargestellter Ausführungsformen näher erläutert. Es zeigen
- Fig. 1: in schematischer Darstellung den Schaltungsaufbau eines erfindungsgemäßen Gerätes mit einem Energieversorgungsteil,
- Fig. 2: in vergrößerter Darstellung einen Teil des Schaltungsaufbaus gemäß Fig. 1,
- Fig. 3: in einer Darstellung entsprechend Fig. 2 eine zweite Ausführungsform des Schaltungsaufbaus des erfindungsgemäßen Gerätes,
- Fig. 4: in einer Darstellung gemäß Fig. 3 den Schaltungsaufbau einer weiteren Ausführungsform eines erfindungsgemäßen Gerätes,
- Fig. 5: in einer Darstellung entsprechend Fig. 3 den Schaltungsaufbau einer weiteren Ausführungsform eines erfindungsgemäßen Gerätes,
- Fig. 6: eine Draufsicht auf eine Kurzschlussleiste des erfindungsgemäßen Gerätes,
- Fig. 7: eine Vorderansicht der Kurzschlussleiste gemäß Fig. 6,
- Fig. 8: eine Seitenansicht der Kurzschlussleiste gemäß Fig. 6,
- Fig. 9: eine Draufsicht auf eine Kontaktstiftleiste des erfindungsgemäßen Gerätes,
- Fig. 10: eine Seitenansicht der Kontaktstiftleiste gemäß Fig. 9,
- Fig. 11: eine Unteransicht der Kontaktstiftleiste gemäß Fig. 9,
- Fig. 12: die Kontaktseite des Energieversorgungsteiles des erfindungsgemäßen Gerätes,
- Fig. 13 bis Fig. 15: jeweils in perspektivischer Darstellung den Entnahmevorgang des Energieversorgungsteiles aus dem erfindungsgemäßen Gerät.

Mit dem Gerät ist es möglich, in explosionsgefährdeten Zonen (Ex-Bereich) das Energieversorgungsteil zu wechseln, ohne dass eine Zündgefahr durch den Wechsel oder während des Wechsels entsteht. Dadurch ist es möglich, die Betriebszeit des Gerätes nahezu beliebig zu verlängern.

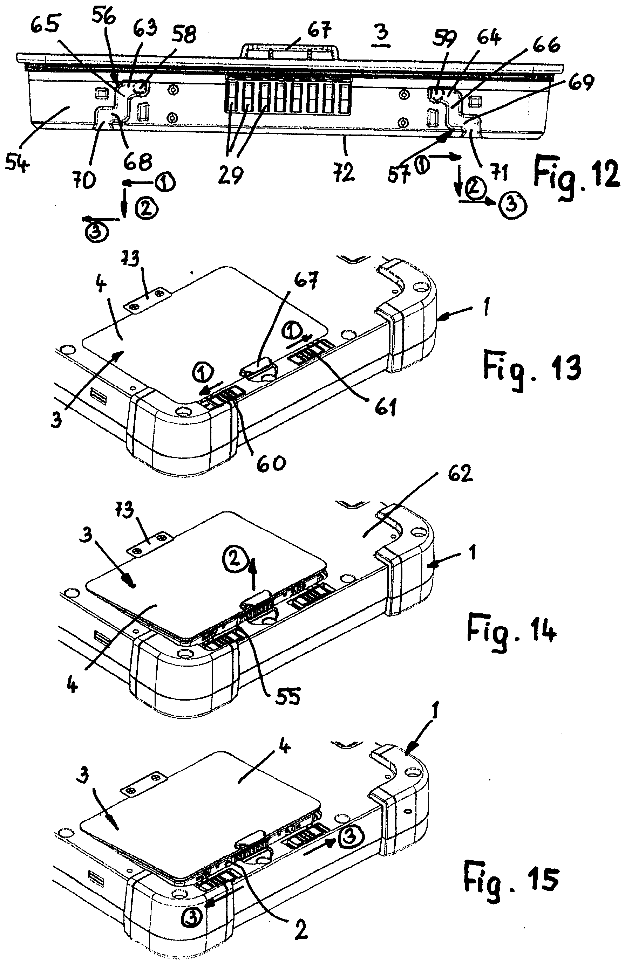

In den Fig. 13 bis 15 ist beispielhaft ein Teil eines solchen Gerätes 1 dargestellt, das zum Beispiel ein Anzeigegerät, ein Messgerät, ein Analysegerät, ein mobiler Computer oder dergleichen sein kann. Es hat ein Aufnahmefach 2 für ein Energieversorgungsteil 3, das mit einem Gehäuse 4 versehen ist, in dem sich wenigstens eine Batterie oder wenigstens ein wiederaufladbarer Akku befindet. Üblicherweise enthält das Gehäuse 4 einen Batterie- oder einen Akkupack, der aus mehreren Einzelzellen besteht.

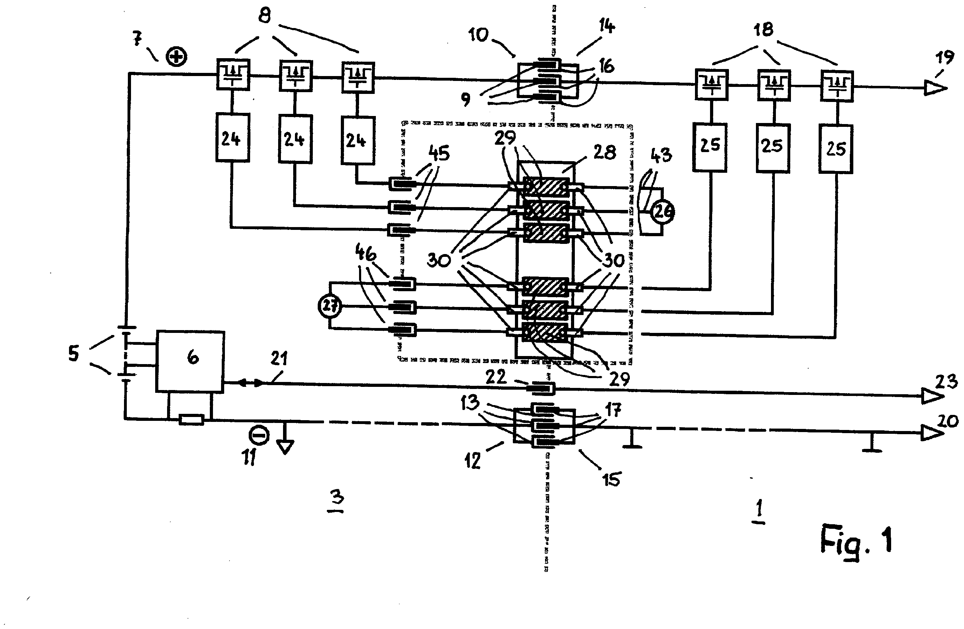

Fig. 1 zeigt schematisch den Schaltungsaufbau des Energieversorgungsteiles 3 und des Gerätes 1.

Mit 5 sind Batterie/Akkumulatorzellen angegeben, die Teile der Batterie/Akkumulatorpacks sind. Diese Packs können eine oder mehrere Primärzellen oder eine oder mehrere Sekundärzellen 5 aufweisen. Im Falle von wiederaufladbaren Akkus bzw. Akkupacks ist im Gehäuse 4 eine Lade/Entladeschaltung 6 untergebracht. Solche Schaltungen sind bekannt und werden darum auch nicht näher erläutert. Mit dieser Schaltung 6 erfolgt auch eine Steuerung sowie Überwachung der Akkumulatorzellen 5.

Weist das Gehäuse 4 Batterien bzw. Batteriepacks auf, können auch dann verschiedene Steuer- oder Überwachungselemente im Gehäuse 4 untergebracht sein.

In Fig. 1 ist beispielhaft eine Batterieschaltung dargestellt, deren Pluspol 7 über wenigstens zwei, im Ausführungsbeispiel über drei in Reihe geschaltete Schalter 8 von Ausgangsklemmen 9 eines positiven Ausgangspols 10 getrennt ist, der einen Versorgungskontakt bildet. Die Schalter 8 sind vorteilhaft Transistoren, insbesondere FETs. Im dargestellten Ausführungsbeispiel sind drei Schalter 8 vorgesehen. Die Zahl dieser Schalter 8 hängt davon ab, in welcher Ex-Bereich-Zone oder Division das Gerät 1 mit dem Energieversorgungsteil 3 eingesetzt werden soll. Bei Einsatz in der Zone 1 reichen zwei Schalter 8 aus, während für den Einsatz in der Ex-Bereich-Zone 0 drei Schalter 8 vorgesehen sind. Beim Einsatz in der Division 1 sind drei Schlter vorgesehen. Diese Redundanz der Schalter 8 gewährleistet, dass bei einem Ausfall eines der Schalter 8 die Funktionssicherheit gewährleistet bleibt.

Der Minuspol 11 der Schaltung ist mit einem negativen Ausgangspol 12 (Versorgungskontakt) verbunden, der mit entsprechenden Ausgangsklemmen 13 versehen ist.

Damit das Energieversorgungsteil 3 in den Ex-Zonen 0, 1, 2 bzw. Divisions 1, 2 eingesetzt werden kann, haben die beiden Ausgangspole 10, 12 jeweils drei Ausgangsklemmen 9, 13.

Das Gerät 1 ist mit einem entsprechenden positiven Eingangspol 14 (Versorgungskontakt) sowie einem entsprechenden negativen Eingangspol 15 (Versorgungskontakt) versehen. Beide Eingangspole 14, 15 weisen eine der Zahl der Ausgangsklemmen 9, 13 entsprechende Zahl von positiven Eingangsklemmen 16 sowie negativen Eingangsklemmen 17 auf.

Der positive Eingangspol 14 des Gerätes 1 ist über wenigstens zwei, im dargestellten Ausführungsbeispiel über drei in Reihe geschaltete Schalter 18 mit dem Pluspol 19 und der negative Eingangspol 15 mit dem Minuspol 19 verbunden.

Die Schalter 18 sind vorteilhaft Transistoren, insbesondere FETs. Die Zahl der Schalter 18 ist wiederum davon abhängig, in welcher Ex-Zone oder Division das Gerät eingesetzt werden soll. Die Redundanz der Schalter 18 stellt sicher, dass bei einem Ausfall eines der Schalter die Funktionssicherheit des Gerätes im jeweiligen Ex-Bereich gewährleistet ist.

Falls die Lade/Entladeschaltung 6 für die Akkus zur Versorgung verwendet wird oder die Batterieschaltung Steuer- und/oder Überwachungsdaten bereitstellt, wird zur Kommunikation zwischen dem Energieversorgungsteil 3 und dem Gerät 1 wenigstens eine Signalleitung 21 bereitgestellt, die über Verbinder 22 mit wenigstens einer Signalleitung 23 des Gerätes leitungsverbunden wird. Diese Signalleitungen 21, 23 sind vorteilhaft bidirektionale Kommunikationsleitungen.

Die Schalter 8 in Form der Transistoren werden jeweils durch Ansteuerschaltungen 24 gesteuert, die für sich bekannt sind. Auch die Schalter 18 in Form der Transistoren werden jeweils durch Ansteuerschaltungen 25 in bekannter Weise gesteuert. Die Ansteuerschaltungen 24, 25 arbeiten unabhängig voneinander und steuern jeweils einen der Transistoren 8, 18.

Das Steuersignal 26 für die Ansteuerschaltungen 24 wird im Gerät 1 und das Steuersignal 27 für die Ansteuerschaltungen 25 im Energieversorgungsteil 3 erzeugt. Die elektronische Verbindung zwischen dem Gerät 1 und dem Energieversorgungsteil bezüglich der Steuersignale 26, 27 erfolgt über eine Kurzschlussleiste 28, die aus elektrisch isolierendem Material besteht und im Gerät 1 oder im Energieversorgungsteil 3 vorgesehen sein kann. Die Kurzschlussleiste 28 kann je nach Ausführung der Kontakte in unterschiedlichen Lagen eingebaut sein, beispielsweise vertikal, horizontal oder schräg.

Auf der Kurzschlussleiste 28 befinden sich Kontakte 29, die vorteilhaft flächig ausgebildet sind und aus elektrisch leitendem, beispielsweise aus metallischem Material bestehen. Die Zuführung der Steuersignale 26, 27 zu den Ansteuerschaltungen 24, 25 erfolgt über Kontaktelemente 30, die vorteilhaft als Federkontaktstifte ausgebildet sind. Wird das Energieversorgungsteil 3 in das Gerät 1 eingelegt, kommen die Kontaktelemente 30 des Gerätes 1 oder des Energieversorgungsteiles 3 in Kontakt mit den Kontaktelementen 30, wodurch die elektrische Verbindung zwischen dem Gerät 1 und dem Energieversorgungsteil 3 bezüglich der Steuersignale 26, 27 hergestellt wird. Ist die Kurzschlussleiste 28 im Gerät 1 untergebracht, dann kommen die Kontaktelemente 30 des Energieversorgungsteiles 3 in Kontakt mit den Kontakten 29. Umgekehrt kommen die Kontaktelemente 30 des Gerätes 1 mit den Kontakten 29 in Kontakt, wenn die Kurzschlussleiste 28 im Energieversorgungsteil 3 untergebracht ist.

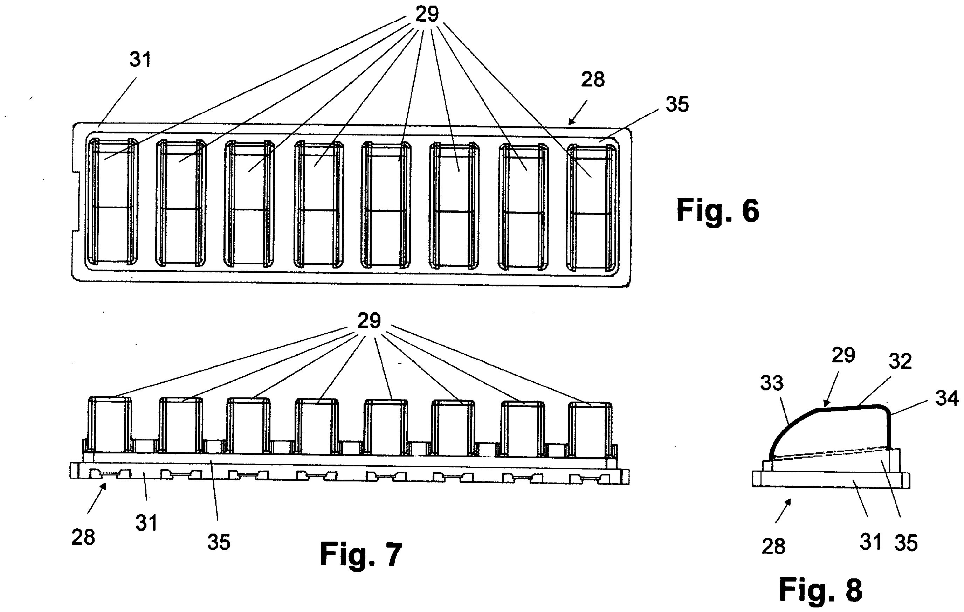

Wie aus den Fig. 6 bis 8 hervorgeht, hat die Kurzschlussleiste 28 einen aus elektrisch isolierendem Material bestehenden Grundkörper 31, der beispielhaft rechteckigen Umriss hat. Die Kontakte 29 sind in geeigneter Weise auf dem Grundkörper 31 der Kurzschlussleiste 28 befestigt. So können die Kontakte 29 auf den Grundkörper 28 beispielsweise geklebt oder gesteckt oder geschraubt werden.

Eine weitere Möglichkeit besteht darin, den Grundkörper 31 zur Bildung der Kontakte 29 metallisch zu bedampfen (plating) oder galvanisch zu beschichten.

Die Kontakte 29 können jede geeignete Form haben. Im dargestellten Ausführungsbeispiel haben die flächigen Kontakte 29 eine schräg verlaufende Kontaktseite 32, die an einem Ende in ein bogenförmiges Endstück 33 übergeht, das sich in Richtung auf die Oberseite des Grundkörpers 31 erstreckt. Am anderen Ende geht die Kontaktseite 32 etwa rechtwinklig in ein gerade verlaufendes Endstück 34 über, das sich bis zum Grundkörper erstreckt.

Wie Fig. 6 zeigt, erstrecken sich die flächigen Kontakte 29 beispielhaft senkrecht zur Längsrichtung der Kurzschlussleiste 28.

Die Kontakte 29 sind vorteilhaft untereinander gleich ausgebildet und liegen mit Abstand, vorteilhaft mit gleichem Abstand, nebeneinander (Fig. 6 und 7).

Die schräge Lage der Kontaktseite 32 ermöglicht eine zuverlässige Verbindung der Kontaktelemente 30 mit den Kontakten 29 beim Einsetzen des Energieversorgungsteiles 3 in das Gerät 1. Um diese vorteilhafte Schräglage der Kontaktseite 32 einfach zu erreichen, ist der Grundkörper 31 der Kurzschlussleiste 28 mit einem Aufsatz 35 versehen, der gemäß Fig. 6 beispielhaft rechteckigen Umriss hat, jedoch geringfügig kleiner als der Grundkörper 31 ist. In Draufsicht auf die Kurzschlussleiste 28 gesehen (Fig. 6), hat dadurch der Umfangsrand des Aufsatzes 35 geringen Abstand vom Umfangsrand des Grundkörpers 31. Die Oberseite des Aufsatzes 35 verläuft schräg, wie insbesondere Fig. 8 zeigt.

Die den Fig. 6 bis 8 entnehmbare Form der Kurzschlussleiste 28 ist nicht beschränkend zu verstehen. Sie kann jede andere geeignete Ausbildung und Form aufweisen, je nachdem, wie das Energieversorgungsteil 3 und/oder das Gerät 1 ausgebildet sind.

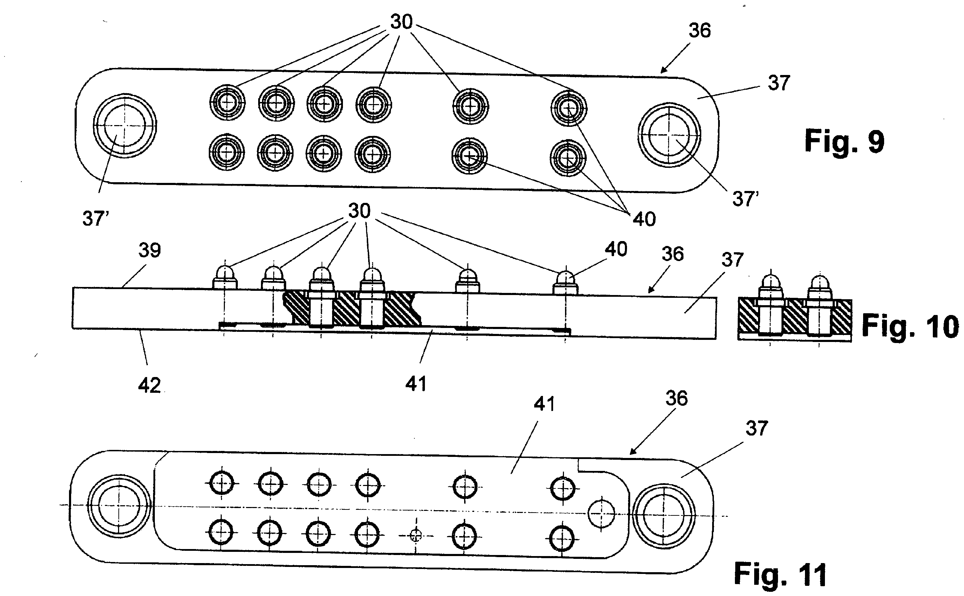

Die mit den Kontakten 29 zusammenwirkenden Kontaktelemente 30 befinden sich auf einer Kontaktleiste 36, wie sie beispielhaft in den Fig. 9 bis 11 dargestellt ist. Die Kontaktleiste 36 hat einen Grundkörper 37, der aus elektrisch isolierendem Material, beispielsweise Kunststoff, besteht und in dem Befestigungsöffnungen 37' vorgesehen sind. Er hat beispielhaft etwa Rechteckform und ist mit Durchgangsöffnungen 38 versehen, durch welche die Kontaktelemente 30 ragen. Sie sind vorteilhaft als Federkontaktstifte ausgebildet. Sie stehen über die Oberseite 39 des Grundkörpers 37 vor. Die Kontaktelemente 30 haben kugelförmige Kontaktflächen 40, wodurch eine zuverlässige Kontaktierung mit den Kontakten 29 gewährleistet ist. Das andere Ende der Kontaktelemente 30 befindet sich innerhalb einer Vertiefung 41 in der Unterseite 42 des Grundkörpers 37. Dadurch stehen die Kontaktelemente 30 nicht über die Unterseite 42 des Grundkörpers 37 vor.

Die Kontaktelemente 30 sind beispielhaft in zwei Reihen mit Abstand neben- und hintereinander angeordnet. Dies ist nur eine beispielhafte Verteilung und Anordnung der Kontaktelemente 30. Die jeweilige Position der Kontaktelemente hängt von der Position der Kontakte 29 der Kurzschlussleiste 28 ab.

Die Kontaktelemente 30 sind in den Durchgangsöffnungen 38 in geeigneter Weise befestigt, beispielsweise eingeklebt oder eingepresst.

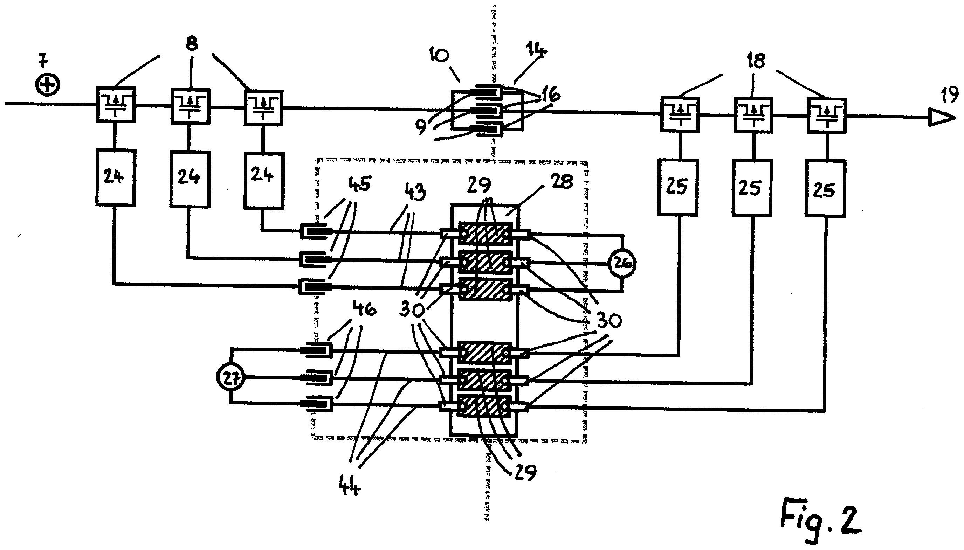

An die in der Vertiefung 41 liegenden Enden der Kontaktelemente 30 sind Steuerleitungen 43, 44 (Fig. 1 und 2) angeschlossen, mit denen die Steuersignale 26, 27 über die Kontakte 29 den Ansteuerschaltungen 24, 25 zugeführt werden (Fig. 1 und 2).

In den Steuerleitungen 43, 44 befinden sich vorteilhaft Steckverbinder 45, 46, so dass beim Abnehmen des Energieversorgungsteiles 3 vom Gerät 1 die Signalverbindung zu den Ansteuerschaltungen 24, 25 unterbrochen wird. Die Steckverbinder 45, 46 befinden sich im Energieversorgungsteil 3.

Die Schalter 8 werden durch die geräteseitigen Steuersignale 26 über die Ansteuerschaltungen 24 freigeschaltet. Gleichzeitig werden die Schalter 18 durch die Steuersignale 27 des Energieversorgungsteiles 3 über die Ansteuerschaltungen 25 freigeschaltet. Durch diese Art der Schaltung wird erreicht, dass ohne das Steuersignal 26 des Gerätes 1 der Ausgangspol 10 und ohne das Steuersignal 27 des Energieversorgungsteiles 3 der Eingang 14 des Gerätes 1 geschlossen bleibt.

Die Ausgangsklemmen 9, 13 und die Eingangsklemmen 16, 17 sind jeweils dreifach vorhanden und können gegenüber den Verbindern 22, 45, 46 vor- oder nacheilend ausgeführt sein, so dass sie beim Einbau oder Ausbau des Energieversorgungsteiles 3 nicht gleichzeitig kontaktiert bzw. voneinander gelöst werden. Auch ist es möglich, die Ausgangsklemmen 9, 13 und die Eingangsklemmen 16, 17 einander gegenüber vor- oder nacheilend auszuführen.

Die Steuersignale 26, 27 werden unabhängig voneinander den jeweiligen Ansteuerschaltungen 24, 25 zugeführt. Die Steuerleitungen 43, 44 sind gegeneinander isoliert, so dass die Steuersignale 26, 27 ungestört der jeweiligen Ansteuerschaltung 24, 25 zugeführt werden können. Bei der Ausführungsform gemäß den Fig. 1 und 2 haben die Steuersignale 26, 27 elektrisch unterschiedliches Potential. Die Ansteuerschaltungen 24, 25 können diskret aus entsprechenden elektrischen/elektronischen Bauteilen aufgebaut sein. Sie können aber auch als integrierte Schaltungen vorliegen.

Die Kontakte 29 der Kurzschlussleiste 28 sind ebenfalls voneinander isoliert, so dass keine Verbindung zu anderen Schaltungsteilen des Gerätes 1 sowie des Energieversorgungsteiles 3 besteht. Die Zuführung der Steuersignale 26, 27 zu den Ansteuerschaltungen 24, 25 erfolgt mit Hilfe der Kontaktelemente 30 der Kontaktleiste 36. Beim Einlegen des Energieversorgungsteiles 3 in das Aufnahmefach 2 des Gerätes 1 gelangen die Kontaktelemente 30 in die dafür vorgesehene Position an den Kontakten 29. Da diese Kontakte 29 isoliert voneinander und von den anderen Kontaktstellen sind, werden die Steuersignale 26, 27 isoliert von anderen Signalen den Ansteuerschaltungen 24, 25 zugeführt.

Über die Kontaktelemente 30 wird detektiert, ob sich im Aufnahmefach 2 das Energieversorgungsteil 3 befindet. Soll das Energieversorgungsteil 3 dem Aufnahmefach 2 entnommen werden, wird über eine mehrstufige Formmimik, die anhand der Fig. 12 bis 15 erläutert wird, sichergestellt, dass das Energieversorgungsteil erst dann entnommen werden kann, wenn die Versorgungskontakte 10, 14; 12, 15 zwischen dem Energieversorgungsteil und dem Gerät 1 spannungs- bzw. stromlos sind. Dadurch kann beim Entfernen des Energieversorgungsteiles 3 kein Zündfunke entstehen.

Die Zuführung der Steuersignale 26, 27 zu den zugehörigen Ansteuerschaltungen 24, 25 kann auch durch Schalter oder Kontaktfederzungen erfolgen, die auf einer Leiste oder direkt im/am Gehäuse 4 des Energieversorgungsteiles 3 oder im/am Gehäuse des Gerätes 1 angebracht sind.

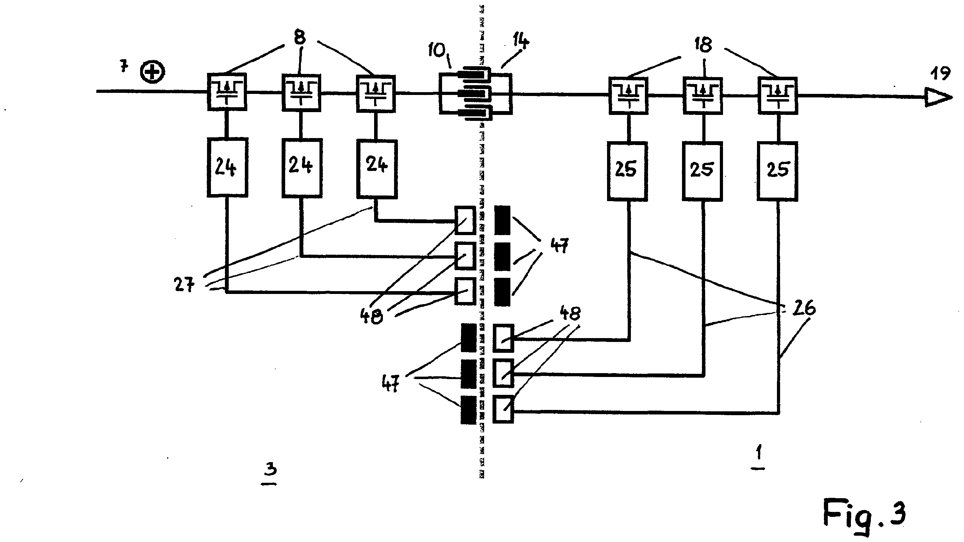

Bei der Ausführungsform gemäß Fig. 3 sind anstelle der unmittelbar in Kontakt miteinander kommenden Kontakte 29 und Kontaktelemente 30 Magnete 47 und Magnetsensoren 48 vorgesehen. Die Steuersignale 26, 27 werden durch magnetische Erregung erzeugt und von den Magnetsensoren 48 den Ansteuerschaltungen 24, 25 zugeführt. Im dargestellten Ausführungsbeispiel sind das Gerät 1 und das Energieversorgungsteil 3 jeweils mit drei Magneten 47 und drei Magnetsensoren 48 versehen. Wird das Energieversorgungsteil 3 in das Aufnahmefach 2 des Gerätes 1 eingesetzt, detektieren die Magnetsensoren 48 die jeweiligen Magnete 47 und erzeugen dadurch die Steuersignale 26, 27. Wie bei der vorigen Ausführungsform werden die Schalter 8, 18 in Form der Transistoren über eine gegenseitige Verschränkung freigeschaltet, so dass wiederum gewährleistet ist, dass die Versorgungskontakte 10, 14; 12, 13 geschlossen bleiben, wenn die Steuersignale 26, 27 nicht ausgelöst werden.

Die im Energieversorgungsteil 3 befindlichen Magnete 47 werden von den entsprechenden, unabhängig voneinander arbeitenden Magnetsensoren 48 im Gerät 1 detektiert. In gleicher Weise detektieren die unabhängig voneinander arbeitenden Magnetsensoren 48 im Energieversorgungsteil 3 die entsprechenden Magnete 47 im Gerät 1.

Die Magnete 47, die Dauermagnete sind, und die Magnetsensoren 48 arbeiten berührungslos zusammen. Im übrigen ist die Schaltung dieses Ausführungsbeispieles gleich ausgebildet und arbeitet in gleicher Weise wie bei der vorigen Ausführungsform.

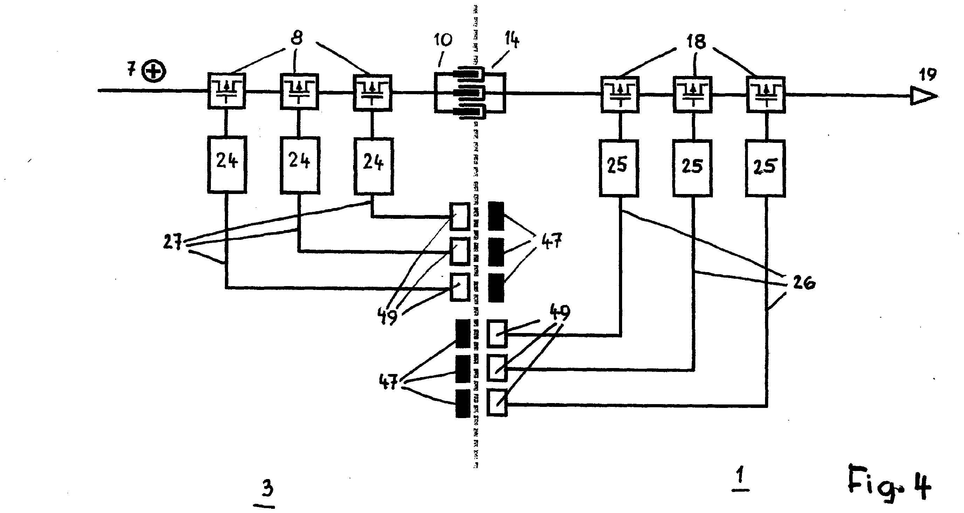

Bei der Ausführungsform gemäß Fig. 4 werden die Steuersignale 26, 27 induktiv erzeugt. Hierzu sind die Magnete 47 und Näherungssensoren 49 vorgesehen. Wie bei der vorigen Ausführungsform weisen das Gerät 1 und das Energieversorgungsteil 3 jeweils drei Dauermagnete 47 und drei Näherungssensoren 49 auf. Die Näherungssensoren 49 sind mit jeweils einer der Ansteuerschaltungen 24, 25 verbunden.

Ebenfalls können Näherungssensoren 49 verwendet werden, die auf die Annäherung von Metallen erregt werden, beispielsweise Eisen. Dann könnten die auslösenden Elemente 47 Metallstücke oder -flächen sein. Bei Annäherung dieser Metallstücke 47 an die Näherungssensoren 49 werden die Steuersignale 26, 27 erzeugt.

Wird das Energieversorgungsteil 3 in das Aufnahmefach 2 des Gehäuses 1 eingesetzt, nähern sich die Näherungssensoren 49 des Energieversorgungsteiles 3 den Dauermagneten 47 des Gerätes 1 und die Dauermagnete 47 des Energieversorgungsteiles 3 den Näherungssensoren 49 des Gerätes 1. Mit jedem Näherungssensor 49 wird eine der Ansteuerschaltungen 24, 25 mit dem jeweiligen Steuersignal 26, 27 versorgt. Wie bei den vorigen Ausführungsformen arbeiten die Näherungssensoren 49 unabhängig voneinander.

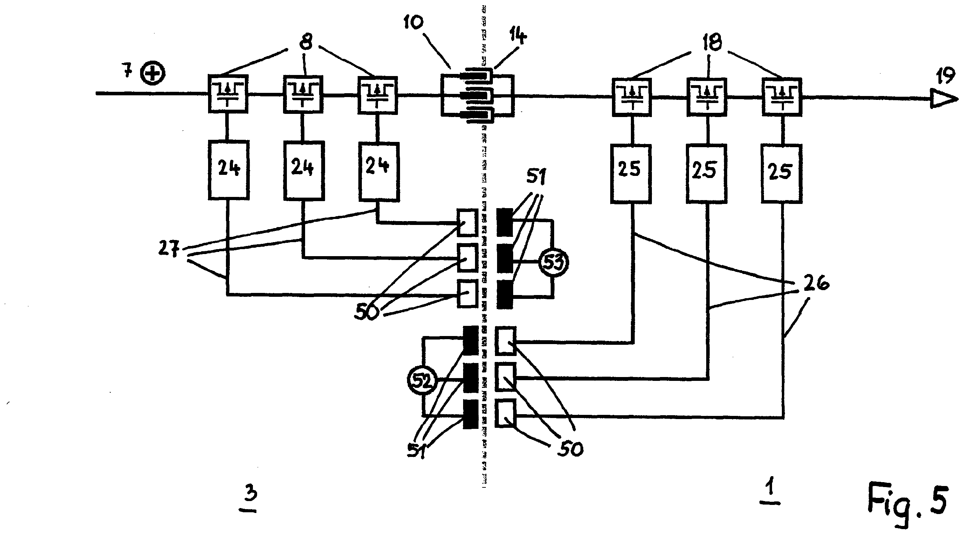

Fig. 5 zeigt eine Ausführungsform, bei welcher die Steuersignale 26, 27 kapazitiv erzeugt werden. Das Gerät 1 und das Energieversorgungsteil 3 haben jeweils die Näherungssensoren 50, die die Steuersignale 26, 27 erzeugen und den Ansteuerschaltungen 24, 25 unabhängig voneinander zuführen.

Das Gerät 1 und das Energieversorgungsteil 3 sind außerdem mit kapazitiv erregenden Flächen 51 versehen, die bei eingesetztem Energieversorgungsteil 3 den jeweiligen Näherungssensoren 50 gegenüberliegen. Bei Annäherung dieser Flächen 51 an die Näherungssensoren 50 werden die Steuersignale 26, 27 erzeugt. Das Potential 52 der im Energieversorgungsteil 3 vorgesehenen kapazitiv erregenden Flächen 51 wird im Energieversorgungsteil 3 erzeugt. Das Potential 53 der kapazitiv erregenden Flächen 51 im Gerät 1 wird im Gerät erzeugt.

Im Übrigen ist die Ausführungsform gemäß Fig. 5 gleich ausgebildet wie das Ausführungsbeispiel nach den Fig. 1 und 2.

Fig. 12 zeigt das Energieversorgungsteil 3 in Seitenansicht. An der Rückseite 54 des Energieversorgungsteiles 3 befinden sich die flächigen Kontakte 29, die in Reihe nebeneinander angeordnet sind. Ist das Energieversorgungsteil 3 in das Aufnahmefach 2 des Gerätes 1 eingesetzt, sind die Kontakte 29 in Eingriff mit den geräteseitigen Kontaktelementen 30, die an der Kontaktleiste 36 vorgesehen sind. Die Kontaktelemente 30 stehen über die der Rückseite 54 des Energieversorgungsteiles 3 zugewandte Seitenwand 55 des Aufnahmefaches 2 vor.

Die Kontakte 29 befinden sich beispielhaft in halber Breite der Rückwand 54 (Fig. 12). Beiderseits der Kontakte 29 sind in der Rückwand 54 Kulissenführungen 56, 57 vorgesehen, die vorteilhaft als Vertiefungen in der Rückwand 54 ausgebildet sind. Die beiden Kulissenführungen 56, 57 sind im angeführten Beispiel spiegelsymmetrisch zueinander angeordnet, um eine Gegenläufigkeit der Öffnungsbewegung zu erzeugen.

In die Kulissenführungen 56, 57 greift jeweils ein Stift 58, 59 ein, der an Schiebern 60, 61 (Fig. 13) vorgesehen ist. Wie den Fig. 13 bis 15 zu entnehmen ist, sind die Schieber 60, 61 an der einen Seite 62 des Gerätes 1 benachbart zum Aufnahmefach 2 angeordnet. Die Schieber 60, 61 liegen vertieft in der Seite 62. Die Stifte 58, 59 stehen von den Schiebern 60, 61 so nach innen ab, dass sie in die Kulissenführungen 56, 57 des Energieversorgungsteiles 3 ragen.

Wenn das Energieversorgungsteil 3 in das Aufnahmefach 2 eingesetzt ist, liegen die Stifte 58, 59 in einem oberen Horizontalabschnitt 63, 64 der beiden Kulissenführungen 56, 57. In dieser Lage sind die Schieber 60, 61 so weit in Richtung zueinander verschoben, dass sie den geringsten Abstand voneinander haben.

Soll das Energieversorgungsteil 3 dem Aufnahmefach 2 entnommen werden, werden die beiden Schieber 60, 61 entgegengesetzt zueinander in Richtung des Pfeiles 1 (Fig. 12 und 13) verschoben. Dadurch gelangen die an den Schiebern 60, 61 vorgesehenen Stifte 58, 59 in einen vertikalen Abschnitt 65, 66 der Kulissenführungen 56, 57. Dann können die Schieber 60, 61 nicht mehr weiter entgegengesetzt zueinander verschoben werden. Das Energieversorgungsteil 3 wird dann mittels eines Griffes 67 in Richtung des Pfeiles 2 (Fig. 14) angehoben. Hierbei verschieben sich die Kulissenführungen 56, 57 relativ zu den in den vertikalen Abschnitten 65, 66 befindlichen Stiften 58, 59, bis diese an einen unteren horizontalen Abschnitt 68, 69 der Kulissenführungen gelangen. Dann lässt sich das Energieversorgungsteil nicht mehr weiter anheben (Fig. 14).

In dieser angehobenen Stellung des Energieversorgungsteiles 3 lassen sich die beiden Schieber 60, 61 entgegengesetzt zueinander in Richtung des Pfeiles 3 (Fig. 12 und 15) verschieben, wodurch die Stifte 58, 59 in den unteren horizontalen Abschnitten 68, 69 der Kulissenführungen 56, 57 verschoben werden.

Die unteren horizontalen Abschnitte 68, 69 gehen dann in vertikal nach unten verlaufende Endabschnitte 70, 71 über, die zur Unterseite 72 des Energieversorgungsteiles 3 offen sind. Dadurch ist es möglich, das Energieversorgungsteil 3 vollständig dem Aufnahmefach 2 zu entnehmen.

Während des Entnahmevorganges wird das Energieversorgungsteil 3 an der gegenüberliegenden Seite von einer Lasche 73 übergriffen. Sie sorgt dafür, dass das Energieversorgungsteil 3 lediglich durch die beschriebene Schwenkbewegung dem Aufnahmefach 2 entnommen werden kann.

Die beschriebene mehrstufige Formmimik sorgt dafür, dass das Energieversorgungsteil 3 nur nach einem mehrstufigen Entriegelungsprozess dem Aufnahmefach 2 entnommen werden kann. Dadurch wird erreicht, dass zunächst die die Steuersignale 26, 27 erzeugende Schaltung 29, 30; 47, 48; 47, 49; 50, 51 die Versorgungskontakte 10, 14; 12, 15 spannungslos schaltet. Dies geschieht bei der Ausführungsform nach den Fig. 1 und 2 dadurch, dass die Kontaktelemente 30 in Form der Federkontaktstifte außer Eingriff mit den Kontakten 29 gelangen. Bei den Ausführungsformen gemäß den Fig. 3 bis 5 werden die Magnete 47 bzw. die kapazitiv erregenden Flächen 51 von den Näherungssensoren 49, 50 entfernt. Erst beim vollständigen Herausnehmen des Energieversorgungsteiles 3 werden dann die Versorgungskontakte 10, 14; 12, 15 voneinander getrennt. Da sie nunmehr spannungslos sind, kann kein Zündfunke beim Entfernen des Energieversorgungsteiles 3 entstehen.

Die beschriebene mehrstufige Formmimik ist nur beispielhaft zu verstehen. Beim Entfernen des Energieversorgungsteiles 3 ist lediglich dafür zu sorgen, dass die Versorgungskontakte 10, 14; 12, 15 zunächst spannungslos geschaltet werden, bevor die Versorgungskontakte voneinander gelöst werden.

Das Energieversorgungsteil 3 muss nicht in ein Aufnahmefach 2 in der beschriebenen Weise einlegbar sein. Vorstellbar ist es auch, das Energieversorgungsteil in ein Einschubfach einzusetzen. In diesem Falle wird das Energieversorgungsteil 3 in das Gerät 1 geschoben. Auch dann kann dafür gesorgt werden, dass beim Herausziehen des Energieversorgungsteiles 3 zunächst die Versorgungskontakte 10, 14; 12, 15 spannungslos geschaltet werden, bevor das Energieversorgungsteil vollständig herausgezogen wird. Hierfür kann beispielhaft auch eine mehrstufige Formmimik in den Seitenwänden des Einschubfaches vorgesehen sein.

## Patentansprüche

1. Gerät (1) zum Einsatz im Ex-Bereich, mit einem Gerätegehäuse und wenigstens einem Energieversorgungsteil (3), das energieseitige Versorgungskontakte (10, 12) aufweist, die mit geräteseitigen Versorgungskontakten (14, 15) zusammenwirken, wenn das Energieversorgungsteil (3) an das Gerät (1) angeschlossen ist, wobei den geräteseitigen Versorgungskontakten (14, 15) erste Schalter (18) vorgeschaltet sind, die vor Trennung des Energieversorgungsteiles (3) vom Gerät (1) mittels einer Schaltung (29, 30; 47, 48; 47, 49; 50, 51) so ansteuerbar sind, dass sie die geräteseitigen Versorgungskontakte (14, 15) spannungslos schalten,
**dadurch gekennzeichnet, dass** das Energieversorgungsteil (3) wenigstens eine Batterie oder wenigstens einen Akku aufweist, dass den energieseitigen Versorgungskontakten (10, 12) zweite Schalter (8) vorgeschaltet sind, die vor Trennung des Energieversorgungsteiles (3) vom Gerät (1) mittels der Schaltung (29, 30; 47, 48; 47, 49; 50, 51) so ansteuerbar sind, dass sie die energieseitigen Versorgungskontakte (10, 12) spannungslos schalten, und dass das Gehäuse des Gerätes (1) und/oder ein Gehäuse (4) des Energieversorgungsteiles (3) mit wenigstens einer mehrstufigen Kulissenführung (56, 57) versehen ist, in die wenigstens ein Kulissenstein (58, 59) eingreift und die so ausgebildet ist, dass beim Entfernen des Energieversorgungsteiles (3) vom Gerät (1) in einer ersten Stufe zunächst über die Schaltung (29, 30; 47, 48; 47, 49; 50, 51) die Versorgungskontakte (10, 14; 12, 15) spannungslos geschaltet und in einer nachfolgenden Stufe die Versorgungskontakte (10, 14; 12, 15) von Gerät (1) und Energieversorgungsteil (3) voneinander gelöst werden.

2. Gerät nach Anspruch 1,
**dadurch gekennzeichnet, dass** die Schaltung (29, 30; 47, 48; 47, 49; 50, 51) die ersten Schalter (18) und die zweiten Schalter (8) bei der Verbindung des Energieversorgungsteiles (3) mit dem Gerät (1) so ansteuert, dass die Versorgungskontakte (10, 14; 12, 15) dann Spannung haben, wenn sie zusammengesteckt sind.

3. Gerät nach Anspruch 1 oder 2,
**dadurch gekennzeichnet, dass** die ersten Schalter (18) und die zweiten Schalter (8) Transistoren sind.

4. Gerät nach einem der Ansprüche 1 bis 3,
**dadurch gekennzeichnet, dass** das Gerät (1) wenigstens zwei erste Schalter (18) und das Energieversorgungsteil (3) wenigstens zwei zweite Schalter (8) aufweist, die unabhängig voneinander ansteuerbar sind.

5. Gerät nach einem der Ansprüche 1 bis 4,
**dadurch gekennzeichnet, dass** die Schaltung (29, 30; 47, 48; 47, 49; 50, 51) Steuersignale (26, 27) für Ansteuerschaltungen (24, 25) erzeugt, mit denen jeder der ersten Schalter (18) und der zweiten Schalter (8) einzeln ansteuerbar ist.

6. Gerät nach einem der Ansprüche 1 bis 5,
**dadurch gekennzeichnet, dass** die Schaltung (29, 30; 47, 48; 47, 49; 50, 51) geräteseitige Schaltelemente (30; 47, 48; 47, 49; 50, 51) und energieseitige Schaltelemente (29; 47, 48; 47, 49; 50, 51) aufweist, von denen die geräteseitigen Schaltelemente die energieseitigen zweiten Schalter (8) und die energieseitigen Schaltelemente die geräteseitigen ersten Schalter (18) betätigen.

7. Gerät nach einem der Ansprüche 1 bis 6,
**dadurch gekennzeichnet, dass** die Schaltung (29, 30) als Schaltelemente Flächenkontakte (29) und mit ihnen zusammenwirkende Kontaktelemente (30), vorzugsweise Federkontaktstifte, aufweist.

8. Gerät nach Anspruch 7,
**dadurch gekennzeichnet, dass** die Flächenkontakte (29) auf einer Kurzschlussleiste (36) vorgesehen sind.

9. Gerät nach Anspruch 7 oder 8,
**dadurch gekennzeichnet, dass** die Kontaktelemente (30) auf einer Kontaktleiste (36) vorgesehen sind.

10. Gerät nach einem der Ansprüche 1 bis 6,
**dadurch gekennzeichnet, dass** die Schaltung (47, 48) als Schaltelemente Dauermagnete (47) und Magnetsensoren (48) aufweist.

11. Gerät nach einem der Ansprüche 1 bis 6,
**dadurch gekennzeichnet, dass** die Schaltung (47, 49; 50, 51) als Schaltelemente Näherungssensoren (49, 50) und mit ihnen zusammenwirkende induktive oder kapazitive Elemente (47, 51) aufweist.

## Claims

1. A device (1) for use in the ex area, comprising a device housing and at least one power supply part (3), which has energy-side supply contacts (10, 12) which interact with device-side supply contacts (14, 15) when the power supply part (3) is connected to the device (1), wherein first switches (18) are connected ahead of the device-side supply contacts (14, 15) which, prior to separation of the power supply part (3) from the device (1), can be controlled by means of a circuit (29, 30; 47, 48; 47, 49; 50, 51) such that they switch the device-side supply contacts (14, 15) so that they are not energized,
**characterized in that** the power supply part (3) has at least one battery or rechargeable battery, that second switches (8) are connected ahead of the energy-side supply contacts (10, 12) which, prior to separation of the power supply part (3) from the device (1), can be controlled by means of the circuit (29, 30; 47, 48; 47, 49; 50, 51) such that they switch the energy-side supply contacts (10, 12) so that they are not energized and that the housing of the device (1) and/or a housing (4) of the power supply part (3) is provided with at least one multistage link guide (56, 57) in which at least one sliding block (58, 59) engages and which is configured so that upon removal of the power supply part (3) from the device (1), in a first step initially the supply contacts (10, 14; 12, 15) are switched so that they are not energized via the circuit (29, 30; 47, 48; 47, 49; 50, 51) and in a subsequent step the supply contacts (10, 14; 12, 15) are released from one another by the device (1) and the power supply part (3).

2. The device according to Claim 1,
**characterized in that** the circuit (29, 30; 47, 48; 47, 49; 50, 51) controls the first switches (18) and the second switches (8) upon connection of the power supply part (3) to the device (1) such that the supply contacts (10, 14; 12, 15) then have voltage when they are plugged together.

3. The device according to Claim 1 or 2,
**characterized in that** the first switches (18) and the second switches (8) are transistors.

4. The device according to one of Claims 1 to 3,
**characterized in that** the device (1) has at least two first switches (18) and the power supply part (3) has at least two second switches (8) which can be controlled independently of one another.

5. The device according to one of Claims 1 to 4,
**characterized in that** the circuit (29, 30; 47, 48; 47, 49; 50, 51) generates control signals (26, 27) for drive circuits (24, 25) by means of which each of the first switches (18) and the second switches (8) can be individually controlled.

6. The device according to one of Claims 1 to 5,
**characterized in that** the circuit (29, 30; 47, 48; 47, 49; 50, 51) has device-side switching elements (30; 47, 48; 47, 49; 50, 51) and energy-side switching elements (29; 47, 48; 47, 49; 50, 51) of which the device-side switching elements actuate the energy-side second switches (8) and the energy-side switching elements actuate the device-side first switches (18).

7. The device according to one of Claims 1 to 6,
**characterized in that** the circuit (29, 30) has as switching elements surface contacts (29) and contact elements (30) interacting with them, preferably spring contact pins.

8. The device according to Claim 7,
**characterized in that** the surface contacts (29) are provided on a short-circuit strip (36).

9. The device according to Claim 7 or 8,
**characterized in that** the contact elements (30) are provided on a contact strip (36).

10. The device according to one of Claims 1 to 6,
**characterized in that** the circuit (47, 48) has as switching elements permanent magnets (47) and magnetic sensors (48).

11. The device according to one of Claims 1 to 6,
**characterized in that** the circuit (47, 49; 50, 51) has as switching elements proximity sensors (49, 50) and inductive or capacitive elements (47, 51) interacting with them.

## Revendications

1. Appareil (1) à utiliser dans une zone à risque d'explosion avec un boîtier d'appareil et au moins une partie d'alimentation en énergie (3), qui comporte des contacts d'alimentation (10, 12) côté énergie, qui coopèrent avec des contacts d'alimentation côté appareil (14, 15), lorsque la partie d'alimentation en énergie (3) est branchée à l'appareil (1), sachant que des premiers connecteurs (18) sont connectés en amont des contacts d'alimentation côté appareil (14, 15), qui peuvent être activés avant la séparation de la partie d'alimentation en énergie (3) de l'appareil (1) au moyen d'un circuit (29, 30 ; 47, 48 ; 47, 49 ; 50, 51) de telle manière qu'ils connectent sans tension les contacts d'alimentation côté appareil (14, 15), **caractérisé en ce que** la partie d'alimentation en énergie (3) comporte au moins une batterie ou au moins un accumulateur, **en ce que** des deuxièmes connecteurs (8) sont connectés en amont des contacts d'alimentation côté énergie (10, 12), qui peuvent être activés avant la séparation de la partie d'alimentation en énergie (3) de l'appareil (1) au moyen du circuit (29, 30 ; 47, 48 ; 47, 49 ; 50, 51) de telle manière qu'ils connectent sans tension les contacts d'alimentation côté énergie (10, 12) et **en ce que** le boîtier de l'appareil (1) et/ou un boîtier (4) de la partie d'alimentation en énergie (3) est doté d'au moins un guidage à coulisse à niveau multiple (56, 57) dans lequel vient en prise au moins un coulisseau (58, 59) et qui est constitué de telle sorte que lors de l'enlèvement de la partie d'alimentation en énergie (3) de l'appareil (1), les contacts d'alimentation (10, 14 ; 12, 15) sont connectés sans tension dans une première étape d'abord par le circuit (29, 30 ; 47, 48 ; 47, 49 ; 50, 51) et les contacts d'alimentation (10, 14 ; 12, 15) sont détachés les uns des autres dans une étape suivante de l'appareil (1) et de la partie d'alimentation en énergie (3).

2. Appareil selon la revendication 1,
**caractérisé en ce que** le circuit (29, 30 ; 47, 48 ; 47, 49 ; 50, 51) active les premiers connecteurs (18) et les deuxièmes connecteurs (8) lors de la liaison de la partie d'alimentation en énergie (3) avec l'appareil (1) de telle manière que les contacts d'alimentation (10, 14 ; 12, 15) ont ensuite de la tension, lorsqu'ils sont interconnectés.

3. Appareil selon la revendication 1 ou 2,
**caractérisé en ce que** les premiers connecteurs (18) et les deuxièmes connecteurs (8) sont des transistors.

4. Appareil selon l'une quelconque des revendications 1 à 3,
**caractérisé en ce que** l'appareil (1) comporte au moins deux premiers connecteurs (18) et la partie d'alimentation en énergie (3) comporte au moins deux deuxièmes connecteurs (8), qui peuvent être activés indépendamment les uns des autres.

5. Appareil selon l'une quelconque des revendications 1 à 4,
**caractérisé en ce que** le circuit (29, 30 ; 47, 48 ; 47, 49 ; 50, 51) produit des signaux de commande (26, 27) pour les circuits d'activation (24, 25) avec lesquels chacun des premiers connecteurs (8) peut être activé individuellement.

6. Appareil selon l'une quelconque des revendications 1 à 5, **caractérisé en ce que** le circuit (29, 30 ; 47, 48 ; 47, 49 ; 50, 51) comporte des éléments de connexion (30 ; 47, 48 ; 47, 49 ; 50, 51) côté appareil et des éléments de connexion (29 ; 47, 48 ; 47, 49 ; 50, 51) côté énergie par lesquels les éléments de connexion côté appareil actionnent les deuxièmes connecteurs côté énergie (8) et les éléments de connexion côté énergie actionnent les premiers connecteurs côté appareil (18).

7. Appareil selon l'une quelconque des revendications 1 à 6,
**caractérisé en ce que** le circuit (29, 30) comporte des contacts de surface (29) et des éléments de contact (30) coopérant avec eux en tant qu'éléments de connexion, de préférence des fiches de contact à ressort.

8. Appareil selon la revendication 7,
**caractérisé en ce que** les contacts de surface (29) sont prévus sur une barrette de court-circuit (36).

9. Appareil selon la revendication 7 ou 8,
**caractérisé en ce que** les éléments de contact (30) sont prévus sur une barrette de contact (36).

10. Appareil selon l'une quelconque des revendications 1 à 6,
**caractérisé en ce que** le circuit (47, 48) comporte des aimants permanents (47) et des capteurs magnétiques (48) en tant qu'éléments de connexion.

11. Appareil selon l'une quelconque des revendications 1 à 6,
**caractérisé en ce que** le circuit (47, 49 ; 50, 51) comporte des capteurs de proximité (49, 50) et des éléments inductifs ou capacitifs (47, 51) coopérant avec eux en tant qu'éléments de connexion.
